# EUROPÄISCHE PATENTANMELDUNG

(11) **EP 4 255 141 A1**
(43) Veröffentlichungstag der Anmeldung: **04.10.2023**
(21) Anmeldenummer: 23164655.5
(22) Anmeldetag: 28.03.2023
(51) Int. Cl.: H05K 7/20

(54) **SELBSTTÄTIG GEZIELT WÄRMEABFÜHRENDE EINHEIT MIT EINER FUNKTIONSEINRICHTUNG**

(30) Priorität: 28.03.2022 DE 102022107292
(71) Anmelder: Yazaki Systems Technologies GmbH, 93059 Regensburg (DE)
(72) Erfinder: WITTMANN, Michael, 93055 Regensburg (DE)
(74) Vertreter: Patentanwaltskanzlei WILHELM & BECK

(57) **Zusammenfassung**

Die Erfindung betrifft eine wärmeerzeugende und gezielt wärmeabführende elektrische Einheit (1), bevorzugt leistungselektrische, hochfrequenzelektrische oder elektrochemische Einheit (1), insbesondere gehaustes Modul (1), gehauste Elektronik (1) oder Batterie (1), mit einer Kapselung (10), einem Verdampfer (20) und einem Kondensator (30), wobei einerseits in der Kapselung (10) der Verdampfer (20) und andererseits durch die und/oder in der Kapselung (10) der Kondensator (30) eingerichtet sind, und in einem hermetischen Innenraum (11) der Kapselung (10) ein Kältemittel (2) zwischen dem Verdampfer (20) und dem Kondensator (30) zirkulierbar eingerichtet ist, wobei einerseits flüssiges Kältemittel (2.1) von einer Abwärme einer Funktionseinrichtung (200) der Einheit (1) in der Kapselung (10) vom Verdampfer (20) verdampfbar ist und/oder verdampft wird, und andererseits verdampftes Kältemittel (2.2) von einer Kälte einer Wärmesenke (300) des Kondensators (30) verflüssigbar ist und/oder verflüssigt wird.

## Beschreibung

Die Erfindung betrifft eine wärmeerzeugende und gezielt wärmeabführende Einheit, bevorzugt eine leistungselektrische, eine hochfrequenzelektrische oder eine elektrochemische etc. Einheit, insbesondere ein gehaustes Modul, eine gehauste Elektronik oder eine Batterie. Ferner betrifft die Erfindung eine Entität mit einer wärmeerzeugenden und gezielt wärmeabführenden Einheit.

Ein Einsatz leistungselektrischer, hochfrequenzelektrischer, elektrochemischer etc. Bauelemente, Bauteile, Komponenten, Baugruppen etc. (ggf. inkl. einem Träger für eine elektronisch realisierbare Funktion) erzeugt z. B. über einen ohmschen Widerstand Abwärme. Hierbei wird auf einer keinen Fläche bzw. in einem kleinen Volumen u. U. sehr viel Abwärme freigesetzt. Deshalb ist eine aktive Kühlung einer leistungselektrischen, hochfrequenzelektrischen, elektrochemischen etc. Einheit notwendig. Bei einer aktiven Kühlung wird die Abwärme mit Hilfe eines Lüfters (aktive Kühlung mit Umgebungsluft) oder einer Flüssigkeitspumpe (aktive Flüssigkeitskühlung meist mit Wasser oder einem Thermoöl) abtransportiert.

Die aktive Kühlung ist der passiven Kühlung von einer Kühlleistung her deutlich überlegen. Problematisch an der aktiven Kühlung sind jedoch neben deren deutlich höheren Design-, Bau- und Installationskosten, insbesondere laufende Kosten, die durch Überwachung, Wartung und Reparatur der aktiven Kühlung anfallen. Ferner benötigt eine aktive Kühlung immer auch zusätzliche Energie (Kosten) und erzeugt somit weitere Abwärme, und arbeitet nicht geräuschlos. - Aufgrund einer gestiegenen Performanz solcher Bauelemente, Bauteile, Komponenten, Baugruppen etc. und/oder permanent kleiner werdender Bauräume in solchen Einheiten tritt zunehmend eine Kühlung in einen Fokus der Entwickler.

Einer betreffenden Umgebung kommt dabei eine zunehmend wichtiger werdende Bedeutung zu. Z. B. auf der Ebene eines Geräts (hier auch: Einheit oder Entität) betrachtet wird eine von einer Baugruppe (hier auch: Funktionseinrichtung oder Einheit) des Geräts erzeugte Abwärme abgeführt und an eine 'Umgebung' direkt innerhalb des Geräts abgegeben. Dadurch erwärmt sich diese innere lokale Baugruppen-Umgebung im Gerät, wobei eine Temperatur im Gerät kleiner als die der Abwärmequelle ist. Diese lokale Baugruppen-Umgebung bzw. das Innere des Geräts wiederum führt die Abwärme über ein Gehäuse des Geräts an eine übergeordnete lokale Umgebung ((übergeordnete) Entität) oder die äußere Umgebung ab.

Angesichts obiger Erläuterungen ist es eine Aufgabe der Erfindung, eine effiziente Kühlung für ein Bauelement, ein Bauteil, eine Komponente, eine Baugruppe etc. (Funktionseinrichtung) in einer leistungselektrischen, einer hochfrequenzelektrischen oder einer elektrochemischen etc. Einheit (vgl. unten) anzugeben, mittels welcher es möglich ist, eine von der Funktionseinrichtung erzeugte Abwärme schnell und effizient an eine übergeordnete lokale Umgebung ((übergeordnete) Entität) oder die äußere Umgebung abzugeben.

Die Aufgabe der Erfindung ist mittels einer wärmeerzeugenden und gezielt wärmeabführenden und insbesondere elektrischen Einheit, bevorzugt einer leistungselektrischen, einer hochfrequenzelektrischen oder einer elektrochemischen etc. Einheit, insbesondere einem gehausten Modul, einer gehausten Elektronik oder einer Batterie, und mittels einer Entität mit einer wärmeerzeugenden und gezielt wärmeabführenden und insbesondere elektrischen Einheit, gemäß den unabhängigen Ansprüchen gelöst. - Vorteilhafte Weiterbildungen, zusätzliche Merkmale und/oder Vorteile der Erfindung ergeben sich aus den abhängigen Ansprüchen und der folgenden Beschreibung.

Die Erfindung besteht darin, für eine technisch-elektrische Einheit, welche z. B. 'weit' innen in einer Entität liegt, weder eine herkömmliche passive (ausschließlich Wärmeleitung) noch eine aktive Kühlung anzuwenden. Eine herkömmliche passive Kühlung ist nicht effizient genug und eine aktive Kühlung solch einer ,weit' innenliegenden Entität ist je nach einem Anwendungsfall oft zu kostenaufwändig, fehleranfällig, aus Platzgründen nicht realisierbar, nachträglich nicht einrichtbar etc. Daher wird gemäß der Erfindung eine Verdampfungskühlung für die Einheit angewendet, wobei die von einer Funktionseinrichtung der Einheit erzeugte Abwärme der Einheit durch ein verdampfendes Kältemittel (Arbeitsmedium in der Einheit) abtransportiert und durch das wieder kondensierende Kältemittel weitergegeben wird.

Die erfindungsgemäße elektrische Einheit umfasst eine Kapselung, einen Verdampfer und einen Kondensator, wobei einerseits in der Kapselung der Verdampfer und andererseits durch die und/oder in der Kapselung der Kondensator eingerichtet sind, und in einem hermetischen Innenraum der Kapselung ein Kältemittel zwischen dem Verdampfer und dem Kondensator zirkulierbar eingerichtet ist, wobei einerseits flüssiges Kältemittel von einer Abwärme einer Funktionseinrichtung der Einheit in der Kapselung vom Verdampfer verdampfbar ist und/oder verdampft wird, und andererseits verdampftes Kältemittel von einer Kälte einer Wärmesenke des Kondensators verflüssigbar ist und/oder verflüssigt wird.

D. h. z. B., dass in der Kapselung das Kältemittel zwischen einerseits (Verdampfer:) der Funktionseinrichtung als aktive Abwärmequelle selbst und/oder einer mit ihr in thermisch leitender Verbindung stehenden Vorrichtung, und andererseits (Kondensator:) der Wärmesenke selbst und/oder einer mit ihr in thermisch leitender Verbindung stehenden Vorrichtung zirkulierbar vorgesehen ist. Hierbei ist/wird einerseits flüssiges Kältemittel an der Funktionseinrichtung als aktive Abwärmequelle selbst und/oder der mit ihr in thermisch leitender Verbindung stehenden Vorrichtung verdampfbar/verdampft (Verdampfer), und ist/wird andererseits verdampftes Kältemittel an der Wärmesenke selbst und/oder der mit ihr in thermisch leitender Verbindung stehenden Vorrichtung verflüssigbar/verflüssigt (Kondensator).

Solch eine gehauste Einheit kann z. B. als eine Vorrichtung (z. B.: elektrischer/elektronischer Baustein), eine Einrichtung (z. B.: Bauteil, Modul, z. B. mit Elektronik, Leiterplatte, Stanzgitter etc.), eine Baugruppe (z. B.: Modul, Batterie, z. B. mit Elektronik, Leiterplatte, Stanzgitter etc.), eine Komponente (Batterie), ein Gerät, ein Apparat, ein Aggregat etc. ausgebildet sein. Insbesondre ist die Einheit als eine gehauste Baugruppe mit wenigstens einem wärmeerzeugenden leistungselektrischen und/oder elektrochemischen Baustein, Bauteil oder Baugruppe ausgebildet. - Die Funktionseinrichtung ist dabei eine Einrichtung der Einheit, welche eine technische Funktion der Einheit realisiert.

Die Einheit selbst bzw. ein wärmetransportierender und wärmeleitender Abschnitt der Einheit ist gemäß der Erfindung als ein Wärmeübertragungselement ausgebildet. Hierdurch lässt sich eine effektive und effiziente Kühlung der Funktionseinrichtung bzw. der gesamten Einheit realisieren, wobei z. B. eine ,weit' innen in einer Entität liegende Einheit, ihre Abwärme schnell an eine Peripherie der Einheit transportieren kann. Hierbei benötigt die erfindungsgemäße Einheit keine zusätzliche Energie und sie arbeitet geräuschlos.

Gemäß der Erfindung wird Abwärme, unter Nutzung der durch die Funktionseinrichtung aufgebrachten Verdampfungsenthalpie, durch das Kältemittel von/bei der Funktionseinrichtung (Verdampfer in der Kapselung) zu der / an die Wärmesenke (Kondensator durch die und/oder in der Kapselung) effizient transportiert und derart die Funktionseinrichtung entwärmt sowie die Wärmesenke gewärmt. Ferner wird gemäß der Erfindung Kälte, unter Nutzung der der Wärmesenke entzogenen Kondensationsenthalpie, durch das Kältemittel von/bei der Wärmesenke (Kondensator durch die und/oder in der Kapselung) zu der / an die Funktionseinrichtung (Verdampfer in der Kapselung) effizient transportiert und derart die Wärmesenke gewärmt sowie die Funktionseinrichtung entwärmt.

Das Kältemittel füllt das Volumen der insbesondere fluiddichten Einheit mit ihrem insbesondere hermetischen Innenraum zu einem kleinen bzw. kleineren Teil mit seiner flüssigen Phase (flüssiges Kältemittel) und zu einem großen bzw. größeren Teil mit seiner dampf- bzw. gasförmigen Phase (verdampftes Kältemittel) aus (das Kältemittel arbeitet also im Nassdampfgebiet bzw. als Nassdampf). Im Rahmen dieser Spezifikation soll der Begriff dampfförmig den Begriff gasförmig mitumfassen. - Hierbei befindet sich die Einheit nicht, wie z. B. bei einem Wärmerohr, zwischen einer externen äußeren (aktiven) Wärmequelle und einer externen äußeren Wärmesenke und ist nicht in einem thermisch leitenden Kontakt mit lediglich dieser Wärmequelle sowie dieser Wärmesenke.

In einem Betrieb der Einheit erwärmt die Funktionseinrichtung einen ersten Bereich bzw. einen ersten Endabschnitt in der Einheit, welcher auch als warmer Bereich bzw. warmer Endabschnitt bezeichenbar ist. Innerhalb seines warmen Bereichs bzw. warmen Endabschnitts fungiert die Einheit als Verdampfer für das Kältemittel. Im Verdampfer kann ein Phasenübergang des Kältemittels von flüssig zu dampfförmig unter Wärmeaufnahme stattfinden. Der Funktionseinrichtung wird im warmen Bereich bzw. im warmen Endabschnitt der Einheit mittels des Kältemittels Abwärme entzogen (Kühlung).

Ferner kühlt im Betrieb der Einheit die Wärmesenke einen zweiten Bereich bzw. einen zweiten Endabschnitt der Einheit, welcher auch als kalter Bereich bzw. kalter Endabschnitt der Einheit bezeichenbar ist. Innerhalb ihres kalten Bereichs bzw. kalten Endabschnitts fungiert die Einheit als Kondensator für das Kältemittel. Im Kondensator kann ein Phasenübergang des Kältemittels von dampfförmig zu flüssig unter Wärmeabgabe stattfinden. Der Wärmesenke wird im kalten Bereich bzw. den kalten Endabschnitt der Einheit mittels des Kältemittels Abwärme zugeführt.

Das Kältemittel ist bevorzugt ein in Bezug auf das thermische Verhalten der Einheit gezielt ausgewähltes Kältemittel. D. h. das Kältemittel ist für gewöhnlich oder insbesondere kein Fluid, welches in einem späteren Betrieb der Einheit in einer Umgebung der Einheit vorliegt. Das thermische Verhalten der Einheit beinhaltet insbesondere eine typischerweise auftretende hohe oder maximale Temperatur der Funktionseinrichtung in der Kapselung. D. h. ein Verdampfungspunkt des Kältemittels liegt etwas unter der hohen oder maximalen Temperatur der Funktionseinrichtung in der Kapselung.

Das Kältemittel ist in der Kapselung thermodynamisch im Nassdampfgebiet betreibbar und/oder wird im Nassdampfgebiet betrieben. Dies gilt natürlich insbesondre für einen Betrieb der Einheit und somit natürlich auch für deren Stillstand. Ferner steht im Wesentlichen das gesamte Kältemittel der Einheit miteinander im Wesentlichen permanent in einer Fluidverbindung. Ein Hintransport des dampfförmigen Kältemittels erfolgt aufgrund eines Druckgradienten, d. h. eines in Richtung der Wärmesenke abnehmenden (Dampf-)Drucks in der Kapselung.

Ein Rücktransport des Kältemittels aus einem Bereich des Kondensators zum Verdampfer kann passiv und/oder aktiv erfolgen bzw. erfolgt passiv und/oder aktiv. Das Kältemittel ist z. B. gravitativ und/oder kapillar zum Verdampfer zurücktransportierbar bzw. wird dorthin zurücktransportiert. Je nach einer Lage und einem Aufbau der Einheit kann ein kapillarer Fluss des Kältemittels durch Kapillaraszension (Flüssigkeitsaufstieg) und/oder Kapillardepression (Flüssigkeitsabstieg) erfolgen. Ferner ist das Kältemittel mittels einer Fördereinrichtung, insbesondere einer Pumpe, zum Verdampfer zurücktransportierbar und/oder wird dorthin zurücktransportiert. Die Fördereinrichtung bzw. Pumpe ist dabei bevorzugt als eine Flüssigkeitsfördereinrichtung bzw. eine Flüssigkeitspumpe ausgebildet.

Die Funktionseinrichtung kann wenigstens teilweise oder im Wesentlichen vollständig in der Kapselung eingerichtet sein. Die Funktionseinrichtung kann als eine wenigstens (vgl. oben) elektrische Abwärmequelle ausgebildet sein. Ferner kann die Funktionseinrichtung einen Träger für eine elektronisch realisierbare Funktion der Einheit aufweisen. - Die Wärmesenke kann als eine aktive und/oder passive Wärmesenke ausgebildet sein Die Wärmesenke kann wenigstens teilweise oder im Wesentlichen vollständig in der Kapselung eingerichtet sein. Ferner kann Wärmesenke der Einheit durch eine Wandung der Kapselung ausgebildet sein.

Die Funktionseinrichtung kann in einem unmittelbaren oder mittelbaren physischen Kontakt mit dem verflüssigten Kältemittel stehen. Der Verdampfer kann in einem unmittelbaren physischen Kontakt mit dem verflüssigten Kältemittel stehen. Ferner kann die Funktionseinrichtung als Verdampfer ausgebildet sein und/oder mit dem eigentlichen Verdampfer der Einheit in einem thermisch gut leitenden Kontakt stehen. - Die Wärmesenke kann in einem unmittelbaren oder mittelbaren physischen Kontakt mit dem verdampften Kältemittel stehen. Der Kondensator kann in einem unmittelbaren physischen Kontakt mit dem verdampften Kältemittel stehen. Ferner kann die Wärmesenke als Kondensator ausgebildet sein und/oder mit dem eigentlichen Kondensator der Einheit in einem thermisch gut leitenden Kontakt stehen. Hierbei kann die Wärmesenke auch außerhalb der Kapselung, insbesondere außen an der Kapselung vorgesehen sein (vgl. unten).

Am und/oder im Verdampfer der Einheit liegt das Kältemittel als flüssiges Kältemittel vor und beginnt zu verdampfen bzw. sieden, wenn dort genügend von der Funktionseinrichtung stammende Abwärme vorhanden ist. Verdampft das flüssige Kältemittel, so steigt dessen Temperatur nicht mehr. Die zugeführte Abwärme wird dann nur noch in Verdampfungsenthalpie des Kältemittels umgesetzt (natürlich nur solange Kältemittel in seiner flüssigen Phase vorliegt). Hierdurch steigt der Fluiddruck am Verdampfer und führt zu einem Druckgefälle in der Einheit in Richtung des Kondensators.

An denjenigen Stellen in der Einheit, wo deren Temperatur den Verdampfungspunkt des Kältemittels unterschreitet, kondensiert das verdampfte Kältemittel. Dies passiert zu gro-ßen Teilen am und/oder im Kondensator, der von der Wärmesenke gekühlt wird. Bei dem kondensierenden Kältemittel sinkt dessen Temperatur so lange nicht, bis die gesamte darin enthaltene Kondensationsenthalpie abgegeben worden ist. Das nun verflüssigte Kältemittel fließt (kriecht) zurück zum Verdampfer, z. B. in ein Kältemittelreservoir. Hierfür kann natürlich auch die Fördereinrichtung angewendet werden. D. h. verdampftes Kältemittel strömt vom Verdampfer zum Kondensator und gleichzeitig fließt verflüssigtes Kältemittel vom Kondensator zum Verdampfer.

Ein Hintransport des verdampften Kältemittels vom Verdampfer zum Kondensator und/oder zu einem anderen Kondensationsbereich innerhalb der Einrichtung kann über eine Hintransport-Einrichtung in der Einheit durch einen Druckgradienten erfolgen. Ein Rücktransport des verflüssigten Kältemittels vom Kondensator und/oder von einem anderen Kondensationsbereich innerhalb der Einrichtung zum Verdampfer kann über eine Rücktransport-Einrichtung in der Einheit kapillar, gravitativ und/oder gefördert erfolgen.

Eine/die Hintransport-Einrichtung kann an oder wenigstens teilweise in einer/der Rücktransport-Einrichtung eingerichtet sein, und/oder eine/die Rücktransport-Einrichtung kann an oder wenigstens teilweise in einer/der Hintransport-Einrichtung eingerichtet sein.

In der Einheit kann kondensiertes Kältemittel z. B. aufgrund von Oberflächenspannungskräften durch Kapillaren oder poröses Kapillarmaterial in Richtung des Verdampfers zurücktransportiert werden. Ferner kann in der Einheit kondensiertes Kältemittel natürlich auch zusätzlich oder ausschließlich mithilfe der Gravitation in Richtung des Verdampfers zurücktransportiert werden. Hierdurch können vergleichsweise große Wärmemengen über kleine Querschnittsflächen hinweg transportiert werden. Ein erzielbarer Wärmestrom wird im Wesentlichen lediglich durch einen verfügbaren Rückfluss des kondensierten Kältemittels begrenzt.

Die Hintransport-Einrichtung für das verdampfte Kältemittel kann einen Strömungsbereich in der Kapselung, eine Drainage und/oder einen Kanal aufweisen. Die Rücktransport-Einrichtung für das verflüssigte Kältemittel kann eine Kapillarvorrichtung, eine Drainage und/oder einen Fließbereich aufweisen. Hierbei kann die Kapillarvorrichtung ein Abschnitt der Kapselung selbst und/oder eine in der Kapselung eingerichtete Vorrichtung sein.

Die Kapillarvorrichtung kann dabei einen porösen Feststoff, z. B. ein gesintertes Metallpulver, einen Kupferschwamm etc.; ein kapillares Gel etc.; ein Schüttgut, z. B. Sand, das durch seine Körnung kapillare Eigenschaften besitzt; etc. aufweisen. Um einen Hintransport des verdampften Kältemittels zu gewährleisten muss ein gewisser Freiraum (Strömungsbereich) vorhanden sein. Bei z. B. einer formstabilen Kapillarvorrichtung kann dies durch eine entsprechende Aussparung in deren Geometrie erflogen, bei einem Schüttgut oder einem Gel kann dies z. B. durch eine zusätzliche dampfdurchlässige Drainage sichergestellt sein.

Die Wärmesenke kann innen in der Kapselung eingerichtet sein, wobei die Wärmesenke bevorzugt als eine aktive Wärmesenke ausgebildet ist. Ferner kann die Wärmesenke zusätzlich oder alternativ außen an der Kapselung vorgesehen sein, wobei die Wärmesenke bevorzugt als eine aktive und/oder passive Wärmesenke ausgebildet ist. - Die Funktionseinrichtung kann wenigstens ein Substrat mit einer sich erwärmenden Komponente aufweisen. Hierbei kann sich die sich erwärmende Komponente wenigstens auch elektrisch, insbesondere ausschließlich elektrisch oder elektrochemisch, erwärmen. Des Weiteren kann die Funktionseinrichtung wenigstens eine Elektronik und/oder wenigstens eine Batteriezelle aufweisen.

Die Kapselung kann mittels eines fluiddichten Gehäuses realisiert sein, wobei das Gehäuse bevorzugt wenigstens einen Topf und wenigstens einen Deckel umfasst. Ferner kann die Kapselung mittels wenigstens einer Wandung der Einheit selbst und mittels wenigstens einer Wand einer zweiten Einheit gebildet sein. Des Weiteren kann die Kapselung mittels einer stofflich einstückigen oder lösbaren fluidgedichteten Verbindung wenigstens zweier Wandungen ihren Innenraum hermetischen abschließen.

Die Einheit kann ferner eine Wärmebrücke aufweisen, mittels welcher zusätzliche Abwärme von außerhalb der Einheit zum Verdampfer transportierbar ist. Hierbei kann die Wärmebrücke in die Kapselung hineinragend und/oder durch die Kapselung wenigstens teilkonstituiert sein. Mittels einer Wärmebrücke kann eine zweite Einheit ihre Abwärme in die Einheit abgeben, welche von der Einheit entsprechend abtransportierbarer ist. - Die Einheit kann ferner eine Kältebrücke aufweisen, mittels welcher Kälte von außerhalb der Einheit zum Kondensator transportierbar ist. Hierbei kann die Kältebrücke in die Kapselung hineinragend und/oder durch die Kapselung wenigstens teilkonstituiert sein. Mittels einer Kältebrücke kann ggf. der Kondensator in der Einheit mit Kälte versorgt werden. Ferner ist mittels einer Kältebrücke zusätzliche Kälte in die Einheit transportierbar.

Durch die wärmeerzeugende und gezielt wärmeabführende elektrische Einheit ergibt sich eine hocheffiziente Wärmeübertragung durch die zusätzliche Funktionsweise der elektrischen Einheit als ein Wärmeübertrager durch Nutzung von Verdampfungsenthalpie. D. h. solch eine Funktionsweise kann kostengünstig und unkompliziert für Komplettgeräte umgesetzt werden. Ferner kann ein z. B. bis dato vorgesehenes Wärmerohr als zusätzliche Komponente entfallen, wodurch Aufwand, Teileanzahl, Montage etc. und somit Kosten deutlich reduziert werden können.

Ferner kann auf aufwändige Durchführungen und Anschlüsse an der Kapselung (Gehäuse), z. B. für ein Wärmerohr, verzichtet werden. Des Weiteren entfallen aufwändige Durchführungen, Anschlüsse, Leitungen etc. für ein Kühlmittel. Darüber hinaus entfallen Orts- und/oder Richtungs-Abhängigkeiten der Einheit in Bezug auf ihre Abwärme. Die Wärmesenke kann, vorausgesetzt die Peripherie lässt dies zu, an nahezu jeder Stelle der Kapselung eingerichtet sein. Hierdurch ergibt sich eine Reduktion benötigter Gehäuse/Anschluss-Varianten.

Die erfindungsgemäße Entität weist eine elektrische und mechanische Schnittstelle zu einer wärmeerzeugenden und gezielt wärmeabführenden elektrischen Einheit auf, wobei die Einheit erfindungsgemäß ausgebildet ist. Die Schnittstelle kann dabei natürlich nur als ein mehr oder weniger kontinuierlicher Übergang der Einheit in die davon abseitige Entität ausgebildet sein. D. h. z. B., dass keine elektrische und/oder mechanische Steckverbindung von der Einheit zur davon abseitigen Entität eingerichtet sein muss. Ferner kann die elektrische und mechanische Schnittstelle natürlich als eine elektromechanische Schnittstelle ausgebildet sein. Solch eine Entität kann z. B. als eine Baugruppe, eine Komponente, ein Gerät, ein Apparat, ein Aggregat etc. ausgebildet sein.

Die Erfindung ist im Folgenden anhand von Ausführungsbeispielen unter Bezugnahme auf die beigefügte schematische und nicht maßstabsgetreue Zeichnung näher erläutert. Abschnitte, Elemente, Bauteile, Einheiten, Komponenten und/oder Schemata, welche eine identische, univoke oder analoge Ausbildung und/ oder Funktion besitzen, sind in der Figurenbeschreibung (s. u.), der Bezugszeichenliste, den Patentansprüchen und in den Figuren (Fig.) der Zeichnung mit denselben Bezugszeichen gekennzeichnet. Eine mögliche, in der Erfindungsbeschreibung (s. o.) nicht erläuterte, in der Zeichnung nicht dargestellte und/oder nicht abschließende Alternative, eine statische und/ oder kinematische Umkehrung, eine Kombination etc. zu den Ausführungsbeispielen der Erfindung bzw. einer Komponente, einem Schema, einer Einheit, einem Bauteil, einem Element oder einem Abschnitt davon, kann ferner der Bezugszeichenliste und/oder der Figurenbeschreibung entnommen werden.

Bei der Erfindung kann ein Merkmal (Abschnitt, Element, Bauteil, Einheit, Komponente, Funktion, Größe etc.) positiv, d. h. vorhanden, oder negativ, d. h. abwesend, ausgestaltet sein. In dieser Spezifikation (Beschreibung (Erfindungsbeschreibung (s. o.), Figurenbeschreibung (s. u.)), Bezugszeichenliste, Patentansprüche, Zeichnung) ist ein negatives Merkmal als Merkmal nicht explizit erläutert, wenn nicht gemäß der Erfindung Wert daraufgelegt ist, dass es abwesend ist. D. h. die tatsächlich gemachte und nicht eine durch den Stand der Technik konstruierte Erfindung darin besteht, dieses Merkmal wegzulassen.

Ein Merkmal dieser Spezifikation kann nicht nur in einer angegebenen Art und/oder Weise, sondern auch in einer anderen Art und/oder Weise angewendet sein (Isolierung, Zusammenfassung, Ersetzung, Hinzufügung, Alleinstellung, Weglassung etc.). Insbesondere ist es möglich, anhand eines Bezugszeichens und einem diesem zugeordneten Merkmal bzw. vice versa, in der Beschreibung, der Bezugszeichenliste, den Patentansprüchen und/oder der Zeichnung, ein Merkmal in den Patentansprüchen und/oder der Beschreibung zu ersetzen, hinzuzufügen oder wegzulassen. Darüber hinaus kann dadurch ein Merkmal in einem Patentanspruch ausgelegt und/oder näher spezifiziert werden.

Die Merkmale der Beschreibung sind (angesichts des (zunächst meist unbekannten) Stands der Technik) auch als optionale Merkmale interpretierbar; d. h. ein jedes Merkmal kann als ein fakultatives, arbiträres oder bevorzugtes, also als ein nicht verbindliches, Merkmal aufgefasst werden. So ist eine Herauslösung eines Merkmals, ggf. inkl. seiner Peripherie, aus einem Ausführungsbeispiel möglich, wobei dieses Merkmal dann auf einen verallgemeinerten Erfindungsgedanken übertragbar ist. Das Fehlen eines Merkmals (negatives Merkmal) in einem Ausführungsbeispiel zeigt, dass das Merkmal in Bezug auf die Erfindung optional ist. Ferner ist bei einem Artbegriff für ein Merkmal auch ein Gattungsbegriff für das Merkmal mitlesbar (ggf. weitere hierarchische Gliederung in Untergattung etc.), wodurch, z. B. unter Beachtung von Gleichwirkung und/oder Gleichwertigkeit, eine Verallgemeinerung des Merkmals möglich ist.

In den lediglich beispielhaften Figuren (Fig.) zeigen jeweils in einer seitlichen Schnittansicht:
die Fig. 1 eine prinzipielle Ausbildung einer erfindungsgemäßen wärmeerzeugenden und gezielt wärmeabführenden elektrischen Einheit mit einer internen Wärmesenke,
die Fig. 2 und 3 jeweils eine Ausführungsform der wärmeerzeugenden und gezielt wärmeabführenden elektrischen Einheit als eine leistungselektrische Einheit, und
die Fig. 4 eine Ausführungsform der wärmeerzeugenden und gezielt wärmeabführenden elektrischen Einheit als eine Batterie.

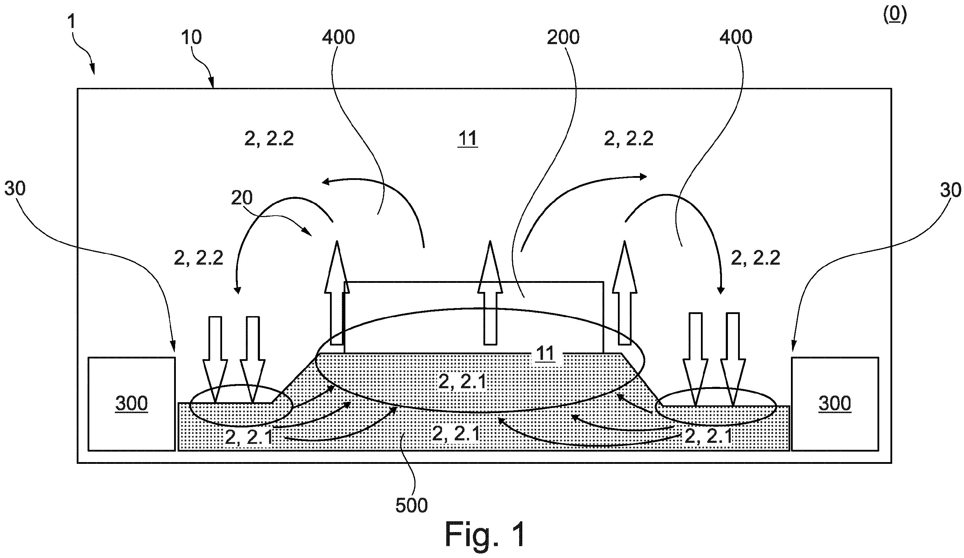

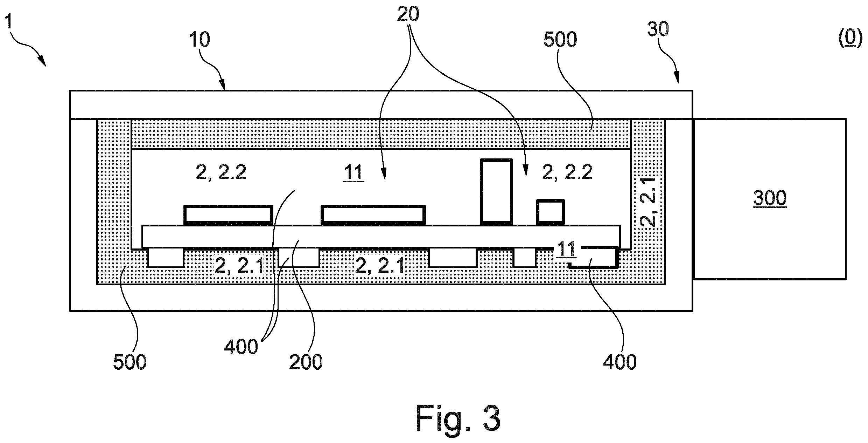

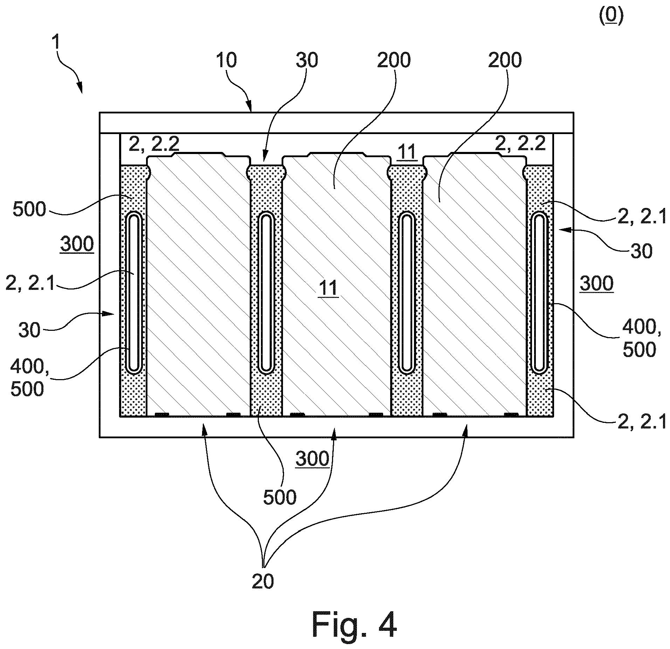

Die Erfindung ist im Folgenden anhand von Ausführungsbeispielen von vier Ausführungsformen (Fig. 1 bis 4) einer Variante einer wärmeerzeugenden und gezielt wärmeabführenden technisch-elektrischen Einheit 1 z. B. einer Entität 0 näher erläutert. Hierbei zeigt die Fig. 1 eine prinzipielle Ausbildung der Einheit 1 mit einer inneren Wärmesenke 300, analog dazu ist eine äußere Wärmesenke 300 vorsehbar (vgl. die Fig. 3 und 4). - Obwohl die Erfindung detaillierter durch Ausführungsformen näher beschrieben und illustriert ist, so ist die Erfindung nicht durch die offenbarten Ausführungsformen eingeschränkt, sondern ist von grundlegenderer Natur. Andere Variationen können hieraus und/oder aus Obigem (Erfindungsbeschreibung) abgeleitet werden, ohne den Schutzumfang der Erfindung zu verlassen.

Die Erfindung ist allgemein im elektrischen Bereich bei einer technischen Entität 0 (vgl. o.) anwendbar. Der elektrische Bereich umfasst z. B. einen energieelektrischen (elektrische Energietechnik und Analoga (sehr hohe bis maximale elektrische Ströme und Spannungen)), leistungselektrischen (ggf. inkl. einem Träger für eine elektronisch realisierbare Funktion), hochfrequenzelektrischen, elektronischen, elektrochemischen, elektrooptischen und/oder elektromechanischen etc. Bereich. - In der Zeichnung sind nur diejenigen räumlichen Abschnitte eines Gegenstands der Erfindung dargestellt, welche für ein Verständnis der Erfindung notwendig sind.

Die Fig. 1 zeigt eine prinzipielle Ausbildung der Einheit 1 mit einer Kapselung 10, welche einen hermetischen Innenraum 11 aufweist, d. h. die Kapselung 10 ist fluiddicht. In und/oder an der Kapselung 10 sind ein aktiver Verdampfer 20, ein aktiver und/oder passiver Kondensator 30 sowie bevorzugt wenigstens eine, insbesondere wenigstens elektrische Funktionseinrichtung 200 der Einheit 1 eingerichtet. Die Funktionseinrichtung 200 ist dabei eine aktive Abwärmequelle 200 der Einheit 1, wobei die Abwärme einerseits von der Funktionseinrichtung 200 abtransportiert und andererseits aus der Einheit 1 heraus transportiert werden muss, um die Funktionstüchtigkeit der Funktionseinrichtung 200 und somit der Einheit 1 zu gewährleisten.

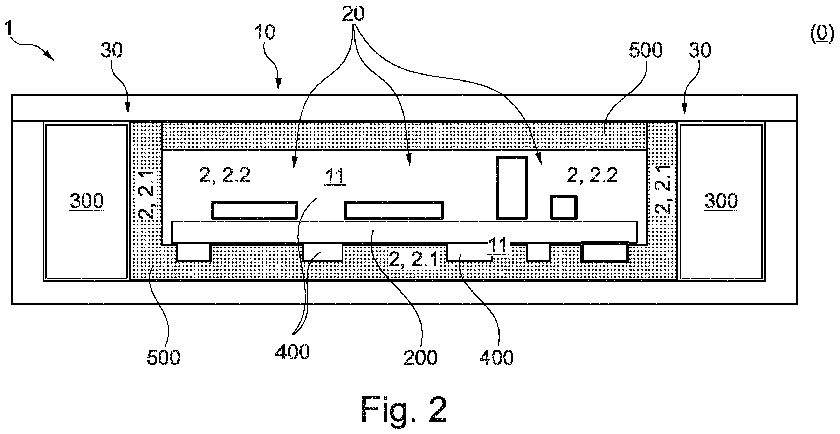

Die Kapselung 10 kann dabei als ein Gehäuse 10 z. B. mit wenigstens einem Topf und wenigstens einem Deckel (vgl. auch Fig. 2 bis 4) ausgebildet sein. Ferner kann die Kapselung 10 mittels wenigstens einer Wandung der Einheit 1 und wenigstens einer zweiten, einheitenfremden Wand z. B. der Entität 0 oder einer anderen Entität konstituiert sein. Andere Realisierungen eines hermetischen Gehäuses 10 sind natürlich anwendbar, wie z. B. eine Einheit 1 als eine Umspritzung beispielsweise einer Leiterplatte, wobei natürlich auch der hermetische Innenraum 11 eingerichtet wird.

Die Funktionseinrichtung 200 kann dabei als der Verdampfer 20 (bzw. vice versa) ausgebildet sein (Fig. 1 bis 4) und/oder mit dem Verdampfer 20 der Einheit 1 in einem thermisch leitenden Kontakt stehen. - Der Kondensator 30 kann dabei als eine Wärmesenke 300 ausgebildet sein und/oder in einem thermisch leitenden Kontakt mit einer/der Wärmesenke 300 stehen. Die Wärmesenke 300 kann dabei als eine aktive und/oder passive sowie innere (vgl. auch die Fig. 3 und 4) und/oder äußere (vgl. auch die Fig. 2) Wärmesenke 300 ausgebildet sein. - Im hermetischen Innenraum 11 kann im Betrieb der Einheit 1 ein 2-Phasen-Kältemittel 2 zwischen dem Verdampfer 20 und dem Kondensator 30 zirkulieren (vgl. die Pfeile in der Fig. 1).

D. h. es wird im Betrieb der Einheit 1 vom Verdampfer 20 flüssiges Kältemittel 2.1 verdampft, wobei die Wärme zum Verdampfen von einer Abwärme der Funktionseinrichtung 200 stammt. Hierbei können natürlich, wie oben erläutert, der Verdampfer 20 und die Funktionseinrichtung 200 miteinander in thermisch leitendem Kontakt stehen, als eine bauliche Einheit ausgebildet sein oder die Funktionseinrichtung 200 als Verdampfer 20 ausgebildet sein.

D. h. ferner, dass im Betrieb der Einheit 1 parallel dazu vom Kondensator 30 verdampftes Kältemittel 2.2 verflüssigt wird, wobei die Wärme zum Verflüssigen von einer Kälte der Wärmesenke 300 stammt. Hierbei können natürlich, wie oben erläutert, der Kondensator 30 und die Wärmesenke 300 miteinander in thermisch leitendem Kontakt stehen, als eine bauliche Einheit ausgebildet sein oder der Kondensator 300 als Wärmesenke 300 ausgebildet sein.

Ein Hintransport (Pfeile weg vom Verdampfer 20 und hin zum Kondensator 30) des verdampften Kältemittels 2.2 erfolgt durch einen Druckgradienten innerhalb der Einrichtung 1 zwischen dem Verdampfer 20 (vergleichsweise hoher Druck) und dem Kondensator 30 (vergleichsweise niedriger Druck). Ein Rücktransport (Pfeile weg vom Kondensator 30 und hin zum Verdampfer 20) des flüssigen Kältemittels 2.1 kann passiv, z. B. gravitativ und/oder kapillar, und/oder aktiv, z. B. mittels einer Fördereinrichtung insbesondere einer Fluidpumpe, erfolgen.

Eine Hintransport-Einrichtung 400 für den Hintransport des verdampften Kältemittels 2.2 zum Kondensator 30 kann z. B. als ein Strömungsbereich 400 (Fig. 1 bis 4), eine Drainage 400 (Fig. 4), ein Kanal 400 (Fig. 2 und 3), eine Leitung etc. in der Einheit 1 ausgebildet sein. Eine Rücktransport-Einrichtung 500 für den Rücktransport des verflüssigten Kältemittels 2.1 zum Verdampfer 20 kann z. B. als eine Kapillarvorrichtung 500 (Fig. 1 bis 4), ein Fließbereich, eine Drainage, ein Kanal, eine Leitung, eine Fluidpumpe etc. ausgebildet sein. Eine Transport-Einrichtung 400/500 kann wenigstens teilweise in einer funktional (Hintransport vs. Rücktransport) entgegengesetzten Transport-Einrichtung 400/500 vorgesehen sein.

Die Rücktransport-Einrichtung 500 kann einen Abschnitt der Kapselung 10 bilden und/oder als eine in der Kapselung 10 eingerichtete Rücktransport-Einrichtung 500 ausgebildet sein. Die Rücktransport-Einrichtung 500 als Kapillarvorrichtung 500 kann z. B. als ein poröser Feststoff 500, ein kapillares Gel 500 oder ein Schüttgut 500 ausgebildet sein. Um einen nötigen Dampfstrom für einen Hintransport des verdampften Kältemittels 2.2 zu gewährleisten, kann in der Rücktransport-Einrichtung 500 ein gewisser Freiraum 400, ein Kanal 400 etc. vorhanden sein (Hintransport-Einrichtung 400). Bei einer formstabilen Kapillarvorrichtung 500 kann dies z. B. durch eine entsprechende Aussparung 400 in deren Geometrie erflogen, bei einem Gel oder einem Schüttgut kann dies z. B. durch eine zusätzliche dampfdurchlässige Drainage 400, einen dampfdurchlässigen Kanal 400 etc. garantiert sein.

Die Fig. 1 zeigt die hermetische Kapselung 10 mit der darin befindlichen, wenigstens elektrischen Funktionseinrichtung 200 der Einheit 1, die neben ihrer Funktion für die Einheit 1 eine aktive Abwärmequelle 200 der Einheit 1 bildet. Hierbei ist die Funktionseinrichtung 200 in der Einheit 1 festsitzend eingerichtet und in einem Kontakt mit einer als Kapillarvorrichtung 500 ausgebildeten Rücktransport-Einrichtung 500 für das Kältemittel 2, wobei die Funktionseinrichtung 200 auf der Kapillarvorrichtung 500 vorgesehen ist. Die Kapillarvorrichtung 500 transportiert verflüssigtes Kältemittel 2.1 zur Funktionseinrichtung 200 (Pfeile in der Kapillarvorrichtung 500).

Die Funktionseinrichtung 200 ist vorliegend ferner als Verdampfer 20 der Einheit 1 ausgebildet und verdampft (mittlere Ellipse in der Fig. 1) im Betrieb der Einheit 1 das ihr von der Kapillarvorrichtung 500 zur Verfügung gestellte flüssige Kältemittel 2.1 (Pfeile weg von der Funktionseinrichtung 200). Hierbei sind die durch die Funktionseinrichtung 200 erzeugten Temperaturen höher als der Siedepunkt des Kältemittels 2 in der Kapselung 10. Das verdampfte Kältemittel 2.2 strömt von der Funktionseinrichtung 200 weg und folgt einem Druckgradienten innerhalb der Kapselung 10.

Der Druckgradient innerhalb der Kapselung 10 richtet sich einerseits durch das am Verdampfer 20 verdampfende (flüssige) Kältemittel 2.1 und andererseits durch das am Kondensator 30 wieder verflüssigende (verdampfte) Kältemittel 2.2 im hermetischen Innenraum 11 ein. Hierbei ist wenigstens ein Kondensator 30 innerhalb der Kapselung 10 eingerichtet. Vorliegend sind zwei Kondensatoren 30 in der Einheit 1 eingerichtet. Das verdampfte Kältemittel 2.2 strömt in Richtung des Druckgradienten in der wenigstens als ein Strömungsbereich 400 in der Kapselung 10 ausgebildeten Hintransport-Einrichtung 400.

Vorliegend bilden jeweils eine aktive Wärmesenke 300 und ein betreffender Abschnitt der Kapillarvorrichtung 500, an welchem aufgrund der Wärmesenke 300 verdampftes Kältemittel 2.2 verflüssigbar ist (Pfeile auf die Kapillarvorrichtung 500 zu, Ellipsen rechts und links in der Fig. 1), einen aktiven Kondensator 30. Natürlich kann ein anderer Abschnitt innerhalb der Einheit 1, an welchem verdampftes Kältemittel 2.2 verflüssigbar ist bzw. verflüssigt wird, ebenfalls als ein Kondensator 30 der Einheit 1 fungieren. Die aktive Wärmesenke 300 ist dabei z. B. von einer externen Kühlflüssigkeit durchströmbar oder von z. B. einem externen Lüfter kühlbar. Alternativ kann ein passiver Kondensator 30 mit einer passiven Wärmesenke 300 eingesetzt sein.

Die Fig. 2 und 3 zeigen beispielhafte Anwendungen der Erfindung auf leistungselektrische Einheiten 1 mit jeweils einem Gehäuse 10 als Kapselung 10, die aus einem Topf und einem Deckel ausgebildet ist. Der fluiddichte Topf und der fluiddichte Deckel sind dabei fluiddicht aneinander festgelegt. Die jeweilige Funktionseinrichtung 200 (aktive Abwärmequelle 200) ist als eine Leiterplatte 200 oder ein Stanzgitter 200 mit wenigstens einem leistungselektrischen Träger und/oder einem Träger für eine (leistungs-)elektronisch realisierbare Funktion ausgebildet. Hierbei bildet die Leiterplatte 200 bzw. deren Abschnitte, welche im Betrieb der Leiterplatte 200 eine Temperatur erreichen können, die über dem Siedepunkt des Kältemittels 2 liegen können, den Verdampfer 20 der Einheit 1.

Die Funktionseinrichtung 200 ist wiederum in der Einheit 1 festsitzend eingerichtet. Das Gehäuse 10 ist innen an wenigstens vier Seiten jeweils wenigstens teilflächig mit der als Kapillarvorrichtung 500 ausgebildeten Rücktransport-Einrichtung 500 für das Kältemittel 2 ausgekleidet, wobei die Funktionseinrichtung 200 innerhalb der Auskleidung auf einem Abschnitt der Kapillarvorrichtung 500 vorgesehen ist. Zwischen der Funktionseinrichtung 200 und diesem Abschnitt der Kapillarvorrichtung 500 kann wenigstens ein Kanal 400 als eine Hintransport-Einrichtung 400 für das verdampfte Kältemittel 2.2 zum Kondensator 30 eingerichtet sein. Hierbei ist der wenigstens eine Kanal 400 bevorzugt in dem Abschnitt der Kapillarvorrichtung 500 eingerichtet. Gegenüberliegend zum wenigstens einen Kanal 400 ist bevorzugt ein Strömungsbereich 400 als Hintransport-Einrichtung 400 für das verdampfte Kältemittel 2.2 eingerichtet.

An wenigstens einer Innenseite (Fig. 2 zwei Innenseiten) und/ oder wenigstens einer Außenseite (Fig. 3 eine Außenseite) des Gehäuses 10 und bevorzugt in einem Kontakt mit einer Wandung des Gehäuses 10 ist eine aktive und/oder passive Wärmesenke 300 wenigstens eines (Fig. 2 zwei, Fig. 3 eine) Kondensators 30 der Einheit 1 eigerichtet. Hierbei bilden eine Wärmesenke 300 und ein betreffender Abschnitt einer Wandung des Gehäuses 10 und/oder ein betreffender Abschnitt der Kapillarvorrichtung 500, an welchem aufgrund der Wärmesenke 300 verdampftes Kältemittel 2.2 verflüssigbar ist, einen aktiven und/oder passiven Kondensator 30.

In der Ausführungsform der Fig. 2 ist eine bevorzugt aktive Wärmesenke 300 seitlich im Gehäuse 10 zwischen einerseits einer Innenwand des Gehäuses 10 und andererseits des betreffenden Abschnitts der Kapillarvorrichtung 500 im Gehäuse 10 eingerichtet. Hierbei bilden die Wärmesenke 300 und der betreffende Abschnitt der Kapillarvorrichtung 500 eine Verbundlage (2er-Sandwich), welche als ein Kondensator 30 für das verdampfte Kältemittel 2.2 dient. Das verdampfte Kältemittel 2.2 kann dabei an/in der Kapillarvorrichtung 500 und/oder außen an der Wärmesenke 300 kondensieren. In der Ausführungsform gemäß der Fig. 2 sind zwei solche, einander gegenüberliegende Wärmesenken 300 zu sehen.

In der Ausführungsform der Fig. 3 ist eine aktive und/oder passive Wärmesenke 300 seitlich außen am Gehäuse 10 vorgesehen. Hierbei bilden die Wärmesenke 300, eine Wandung des Gehäuses 10 und ein betreffender Abschnitt der Kapillarvorrichtung 500 eine Verbundlage (3er-Sandwich), welche als ein Kondensator 30 für das verdampfte Kältemittel 2.2 dient. Das verdampfte Kältemittel 2.2 kann dabei an der Wandung und/oder an/in der Kapillarvorrichtung 500 kondensieren. In der Ausführungsform gemäß der Fig. 3 ist eine solche Wärmesenke 300 zu sehen.

Die Fig. 4 zeigt eine beispielhafte Anwendung der Erfindung auf eine Batterie 1 (Akkumulator 1) mit einem fluiddichten Gehäuse 10 als Kapselung 10, in welchem die Batteriezellen der Batterie 1 eingerichtet sind. Die Funktionseinrichtung 200 (aktive Abwärmequelle 200) der Batterie 1 umfasst dabei deren Batteriezellen 200. Im Betrieb (Leistungsaufnahme bzw. Leistungsabgabe) der Batterie 1 kann die Funktionseinrichtung 200 bzw. können die Batteriezellen 200, bzw. können Abschnitte davon, eine Temperatur erreichen, welche über dem Siedepunkt des Kältemittels 2 liegt. Die Funktionseinrichtung 200 bzw. die Batteriezellen 200, bzw. die Abschnitte davon bilden den Verdampfer 20 der Batterie 1.

Im Gehäuse 10 ist eine Kapillarvorrichtung 500 eingerichtet, wobei die Funktionseinrichtung 200 bzw. die Batteriezellen 200 in die Kapillarvorrichtung 500 wenigstens teilweise eingebettet sind. Vorliegend sitzt eine jede Batteriezelle bevorzugt mittelbar auf einem Boden des Gehäuses 10, erstreckt sich mit ihrer Längserstreckung durch die Kapillarvorrichtung 500 hindurch, wobei ein vergleichsweise kurzer Längsendabschnitt der jeweiligen Batteriezelle und/oder deren jeweiliges freies Ende nicht mehr in die Kapillarvorrichtung 500 eingebettet ist.

In der Ausführungsform der Fig. 4 ist wenigstens eine aktive und/oder passive Wärmesenke 300 (lediglich Darstellung des Bezugszeichens) seitlich außen am Gehäuse 10 vorgesehen. Hierbei bilden die Wärmesenke 300, eine jeweilige Wandung des Gehäuses 10 und/oder ein betreffender Abschnitt der Kapillarvorrichtung 500 einen Kondensator 30 für das verdampfte Kältemittel 2.2. Das verdampfte Kältemittel 2.2 kann dabei an der Wandung und/oder an/in der Kapillarvorrichtung 500 kondensieren.

In der Ausführungsform gemäß der Fig. 4 sind drei solche Wärmesenken 300 zu sehen, wobei natürlich wenigstens zwei davon zu einer zusammengefasst sein können. Ferner ist es möglich, das gesamte Gehäuse 10 in einem weiteren Gehäuse einzurichten, wobei das weitere Gehäuse als eine Wärmesenke 300 für die Batterie 1 fungieren kann. Hierbei können dann die Seitenwendungen und die Bodenwandung der Batterie 1, ggf. auch nur abschnittsweise, in dem weiteren Gehäuse eingerichtet sein.

Hierbei kann die Kapillarvorrichtung 500 als ein poröser Feststoff 500, ein kapillares Gel 500 oder ein Schüttgut 500 ausgebildet sein. Kanäle 400 in der Kapillarvorrichtung 500 als poröser Feststoff 500 oder Drainagen 400 in der Kapillarvorrichtung 500 als kapillares Gel 500 oder Schüttgut 500 gewährleisten einen zur adäquaten Kühlung notwendigen Dampfstrom zum Kondensator 30 bzw. in Richtung der Wärmesenke(n) 300.

### Bezugszeichenliste

- 0: (technische) Entität

- 1: wärmeerzeugende und gezielt wärmeabführende technisch-elektrische Einheit
- 2: (2-Phasen-)Kältemittel der Einheit 1
- 2.1: verflüssigtes/flüssiges Kältemittel 2
- 2.2: verdampftes/dampf- bzw. gasförmiges Kältemittel 2

- 10: Kapselung, z. B. Gehäuse der Einheit 1
- 11: hermetischer Innenraum
- 20: (aktiver) Verdampfer der Einheit 1
- 30: (aktiver und/oder passiver) Kondensator der Einheit 1

- 200: (bevorzugt wenigstens eine, wenigstens elektrische) Funktionseinrichtung der Einheit 1, als aktive Abwärmequelle der Einheit 1 ausgebildet
- 300: (aktive und/oder passive) Wärmesenke des Kondensators 30
- 400: Hintransport-Einrichtung (durch Druckgradienten) des verdampften Kältemittels 2.2 zum erneuten Kondensieren
- 500: Rücktransport-Einrichtung (kapillar, gravitativ und/oder gefördert) des verflüssigten Kältemittels 2.1 zum erneuten Verdampfen

## Patentansprüche

1. Wärmeerzeugende und gezielt wärmeabführende elektrische Einheit (1), bevorzugt leistungselektrische, hochfrequenzelektrische oder elektrochemische Einheit (1), insbesondere gehaustes Modul (1), gehauste Elektronik (1) oder Batterie (1), mit einer Kapselung (10), einem Verdampfer (20) und einem Kondensator (30), **dadurch gekennzeichnet, dass**
einerseits in der Kapselung (10) der Verdampfer (20) und andererseits durch die und/oder in der Kapselung (10) der Kondensator (30) eingerichtet sind, und in einem hermetischen Innenraum (11) der Kapselung (10) ein Kältemittel (2) zwischen dem Verdampfer (20) und dem Kondensator (30) zirkulierbar eingerichtet ist, wobei
einerseits flüssiges Kältemittel (2.1) von einer Abwärme einer Funktionseinrichtung (200) der Einheit (1) in der Kapselung (10) vom Verdampfer (20) verdampfbar ist und/oder verdampft wird, und andererseits verdampftes Kältemittel (2.2) von einer Kälte einer Wärmesenke (300) des Kondensators (30) verflüssigbar ist und/oder verflüssigt wird.

2. Wärmeerzeugende und gezielt wärmeabführende elektrische Einheit (1) gemäß vorhergehendem Anspruch, **dadurch gekennzeichnet, dass**:
• das Kältemittel (2) ein in Bezug auf das thermische Verhalten der Einheit (1) gezielt ausgewähltes Kältemittel (2) ist,
• das Kältemittel (2) in der Kapselung (10) thermodynamisch im Nassdampfgebiet (2.1, 2.2) betreibbar ist und/oder betrieben wird, und/oder
• im Wesentlichen das gesamte Kältemittel (2) der Einheit (1) miteinander (2.1, 2.2) im Wesentlichen permanent in einer Fluidverbindung steht.

3. Wärmeerzeugende und gezielt wärmeabführende elektrische Einheit (1) gemäß einem der vorhergehenden Ansprüche, **dadurch gekennzeichnet, dass**:
• ein Rücktransport des Kältemittels (2) aus einem Bereich des Kondensators (30) zum Verdampfer (20) passiv und/oder aktiv erfolgbar ist und/oder erfolgt,
• das Kältemittel (2) gravitativ und/oder kapillar zum Verdampfer (20) zurücktransportierbar ist und/oder zurücktransportiert wird, und/oder
• das Kältemittel (2) mittels einer Fördereinrichtung, insbesondere einer Pumpe, zum Verdampfer (20) zurücktransportierbar ist und/oder zurücktransportiert wird.

4. Wärmeerzeugende und gezielt wärmeabführende elektrische Einheit (1) gemäß einem der vorhergehenden Ansprüche, **dadurch gekennzeichnet, dass** die Funktionseinrichtung (200):
• wenigstens teilweise oder im Wesentlichen vollständig in der Kapselung (10) eingerichtet ist,
• als eine wenigstens elektrische Abwärmequelle (200) ausgebildet ist, und/oder
• einen Träger für eine elektronisch realisierbare Funktion der Einheit (1) aufweist.

5. Wärmeerzeugende und gezielt wärmeabführende elektrische Einheit (1) gemäß einem der vorhergehenden Ansprüche, **dadurch gekennzeichnet, dass** die Wärmesenke (300):
• als eine aktive und/oder passive Wärmesenke (300) ausgebildet ist,
• wenigstens teilweise oder im Wesentlichen vollständig in der Kapselung (10) eingerichtet ist, und/oder
• der Einheit (1) durch eine Wandung der Kapselung (10) ausgebildet ist.

6. Wärmeerzeugende und gezielt wärmeabführende elektrische Einheit (1) gemäß einem der vorhergehenden Ansprüche, **dadurch gekennzeichnet, dass**:
• die Funktionseinrichtung (200) in einem unmittelbaren oder mittelbaren physischen Kontakt mit dem verflüssigten Kältemittel (2.1) steht,
• der Verdampfer (20) in einem unmittelbaren physischen Kontakt mit dem verflüssigten Kältemittel (2.1) steht, und/oder
• die Funktionseinrichtung (200) als Verdampfer (20) ausgebildet ist und/oder mit dem eigentlichen Verdampfer (20) der Einheit (1) in einem thermisch leitenden Kontakt steht.

7. Wärmeerzeugende und gezielt wärmeabführende elektrische Einheit (1) gemäß einem der vorhergehenden Ansprüche, **dadurch gekennzeichnet, dass**:
• die Wärmesenke (300) in einem unmittelbaren oder mittelbaren physischen Kontakt mit dem verdampften Kältemittel (2.2) steht,
• der Kondensator (30) in einem unmittelbaren physischen Kontakt mit dem verdampften Kältemittel (2.2) steht, und/oder
• die Wärmesenke (300) als Kondensator (30) ausgebildet ist und/oder mit dem eigentlichen Kondensator (30) der Einheit (1) in einem thermisch leitenden Kontakt steht.

8. Wärmeerzeugende und gezielt wärmeabführende elektrische Einheit (1) gemäß einem der vorhergehenden Ansprüche, **dadurch gekennzeichnet, dass**:
• ein Hintransport des verdampften Kältemittels (2.2) vom Verdampfer (20) zum Kondensator (30) und/oder zu einem anderen Kondensationsbereich innerhalb der Einrichtung (1), über eine Hintransport-Einrichtung (400) in der Einheit (1) durch einen Druckgradienten erfolgt,
• ein Rücktransport des verflüssigten Kältemittels (2.1) vom Kondensator (30) und/oder von einem anderen Kondensationsbereich innerhalb der Einrichtung (1) zum Verdampfer (20), über eine Rücktransport-Einrichtung (500) in der Einheit (1) kapillar, gravitativ und/oder gefördert erfolgt, und/oder
• eine/die Hintransport-Einrichtung (400) an oder wenigstens teilweise in einer/der Rücktransport-Einrichtung (500) eingerichtet ist, und/oder eine/die Rücktransport-Einrichtung (500) an oder wenigstens teilweise in einer/der Hintransport-Einrichtung (400) eingerichtet ist.

9. Wärmeerzeugende und gezielt wärmeabführende elektrische Einheit (1) gemäß einem der vorhergehenden Ansprüche, **dadurch gekennzeichnet, dass**:
• die Hintransport-Einrichtung (400) für das verdampfte Kältemittel (2.2) einen Strömungsbereich (400) in der Kapselung (10), eine Drainage (400) und/oder einen Kanal (400) aufweist,
• die Rücktransport-Einrichtung (500) für das verflüssigte Kältemittel (2.1) eine Kapillarvorrichtung (500), eine Drainage (500) und/oder einen Fließbereich (500) aufweist, und/oder
• die Kapillarvorrichtung (500) ein Abschnitt der Kapselung (10) selbst und/oder eine in der Kapselung (10) eingerichtete Vorrichtung ist.

10. Wärmeerzeugende und gezielt wärmeabführende elektrische Einheit (1) gemäß einem der vorhergehenden Ansprüche, **dadurch gekennzeichnet, dass**
die Wärmesenke (300) innen in der Kapselung (10) eingerichtet ist, wobei die Wärmesenke (300) bevorzugt als eine aktive Wärmesenke (300) ausgebildet ist, und/oder
die Wärmesenke (300) außen an der Kapselung (10) vorgesehen ist, wobei die Wärmesenke (300) bevorzugt als eine aktive und/oder passive Wärmesenke (300) ausgebildet ist.

11. Wärmeerzeugende und gezielt wärmeabführende elektrische Einheit (1) gemäß einem der vorhergehenden Ansprüche, **dadurch gekennzeichnet, dass**:
• die Funktionseinrichtung (200) wenigstens ein Substrat mit einer sich erwärmenden Komponente aufweist,
• die sich erwärmende Komponente wenigstens auch elektrisch, insbesondere ausschließlich elektrisch oder elektrochemisch, erwärmt, und/oder
• die Funktionseinrichtung (200) wenigstens eine Elektronik und/oder wenigstens eine Batteriezelle aufweist.

12. Wärmeerzeugende und gezielt wärmeabführende elektrische Einheit (1) gemäß einem der vorhergehenden Ansprüche, **dadurch gekennzeichnet, dass** die Kapselung (10):
• mittels eines fluiddichten Gehäuses (10) realisiert ist, wobei das Gehäuse (10) bevorzugt wenigstens einen Topf und wenigstens einen Deckel umfasst,
• mittels wenigstens einer Wandung der Einheit (1) selbst und mittels wenigstens einer Wand einer zweiten Einheit (1) gebildet ist, und/oder
• mittels einer stofflich einstückigen oder lösbaren fluidgedichteten Verbindung wenigstens zweier Wandungen ihren Innenraum (11) hermetischen abschließt.

13. Wärmeerzeugende und gezielt wärmeabführende elektrische Einheit (1) gemäß einem der vorhergehenden Ansprüche, **dadurch gekennzeichnet, dass**:
• die Einheit (1) ferner eine Wärmebrücke aufweist, mittels welcher zusätzliche Abwärme von außerhalb der Einheit (1) zum Verdampfer (20) transportierbar ist,
• die Wärmebrücke in die Kapselung (10) hineinragend und/oder durch die Kapselung (10) wenigstens teilkonstituiert ist,
• die Einheit (1) ferner eine Kältebrücke aufweist, mittels welcher Kälte von außerhalb der Einheit (1) zum Kondensator (30) transportierbar ist, und/oder
• die Kältebrücke in die Kapselung (10) hineinragend und/oder durch die Kapselung (10) wenigstens teilkonstituiert ist.

14. Entität (0) mit einer wärmeerzeugenden und gezielt wärmeabführenden elektrischen Einheit (1), mit
einer elektrischen und mechanischen Schnittstelle zur wärmeerzeugenden und gezielt wärmeabführenden elektrischen Einheit (1), **dadurch gekennzeichnet, dass**
die wärmeerzeugende und gezielt wärmeabführende elektrische Einheit (1) gemäß einem der vorhergehenden Ansprüche ausgebildet ist.
